# EUROPÄISCHE PATENTSCHRIFT

(11) **EP 1 159 861 B1**
(45) Veröffentlichungstag und Bekanntmachung des Hinweises auf die Patenterteilung: **17.11.2004**
(21) Anmeldenummer: 00916787.5
(22) Anmeldetag: 01.03.2000
(51) Int. Cl.: H05K 13/04

(54) **VORRICHTUNG ZUM BESTÜCKEN EINES SUBSTRATS MIT FLIP-CHIPS**
DEVICE FOR FITTING A SUBSTRATE WITH A FLIP CHIP
DISPOSITIF D'IMPLANTATION DE PUCES A PROTUBERANCES SUR UN SUBSTRAT

(30) Priorität: 05.03.1999 DE 19909775
(43) Veröffentlichungstag der Anmeldung: 05.12.2001
(73) Patentinhaber: Siemens Aktiengesellschaft, 80333 München (DE)
(72) Erfinder: SCHIEBEL, Günter, D-81379 München (DE)
(74) Vertreter: Zedlitz, Peter, Dipl.-Inf.
(86) Internationale Anmeldenummer: PCT/DE2000/000612
(87) Internationale Veröffentlichungsnummer: WO 2000/054564

(56) Entgegenhaltungen:
- US-A- 5 667 129
- US-A- 5 839 187

## Beschreibung

Die Erfindung betrifft eine Vorrichtung zum Bestücken eines als Schaltungsträger ausgebildeten Substrats mit Flip-Chips, wobei die Vorrichtung einen verfahrbaren Bestückkopf aufweist, der die Flip-Chips aus einem Bauelementevorrat entnimmt und auf das Substrat aufsetzt.

Derartige Flip-Chips sind üblicherweise mit ihren Anschlußelementen nach oben weisend bereitgestellt. Sogenannte Wafer-Handler sind mit einer Wendeeinrichtung für die Flip-Chips versehen, so daß der in einer Bestückebene verfahrbare Bestückkopf einer Bestückvorrichtung die Flip-Chips in ihrer richtigen Einbaulage aufnehmen und an der dafür vorgesehenen auf eine Leiterplatte aufsetzen kann.

Die Flip-Chips sind z.B. nach der JP 1-61027 A (vgl. Patent. Abstracts of Japan, vol. 13, No.270, vom 21. Juli 1989) in einem Wafer mit ihren Anschlußelementen nach oben weisend bereitgestellt. Ein verfahrbarer Entnahmekopf eines Wafer-Handlers entnimmt die Flip-Chips vom Wafer und legt sie auf einer stationären Wendeeinrichtung ab, mittels der sie in einer gewendeten Lage auf einer Übergabestation derart abgelegt werden, aus der sie der Entnahmekopf aufnimmt und in der richtigen Einbaulage mit den Anschlüssen nach unten auf ein Halbleiter-Substrat aufsetzt, das üblicherweise als bandartiges Leadframe zur Herstellung von gehäusten Bauelementen ausgebildet ist und taktweise durch die Aufsetzstation hindurchgeführt wird.

Ferner ist durch die US 5 839 187 eine Vorrichtung zum Handhaben von Flip-Chips bekannt geworden, bei der die Flip-Chips mittels eines Greifers von einem Wafer entnommen werden. Der Greifer wird um eine horizontale Achse geschwenkt und in einer Ubergabestation gewendet an einen Positioniergreifer übergeben, der die Flip-Chips in ein Flächenmagazin ablegt.

Ferner ist durch die US 5 667 129 A (Anspruch 7) ein Bestückkopf zum Bestücken eines Substrates mit Flip-Chips, wobei der Bestückkopf eine nicht näher dargestellte Wendeeinrichtung für die Flip-Chips aufweist.

Der Erfindung liegt die Aufgabe zugrunde, den Vorrichtungsaufwand für die Bestückung der Substrate zu verringern.

Diese Aufgabe wird durch die Erfindung gemäß Anspruch 1 gelöst. Der frei positionierbare Bestückkopf kann in einem Positioniersystem so verfahren werden, daß sein Verfahrbereich den gesamten Waferbereich und das z.B. als Leiterplatte ausgebildete feststehende Substrat Überdeckt. Der Bestückkopf kann daher die Flip-Chips unmittelbar vom Wafer entnehmen, über das Substrat verfahren, in der Zeit zwischen dem Abholen und dem Aufsetzen auf das Substrat in seiner mitfahrenden Wendeeinrichtung wenden und den Flip-Chip, nach dem Wenden auf das Substrat aufsetzen. Durch diese Maßnahme können alle wesentlichen Funktionen des Abholens, transportierens, Wendens und aufsetzens der Bauelement3 mit einem einzigen Handhabungssystem zeitsparend durchgeführt werden, wodurch auf den Wafer-Handler völlig verzichtet werden kann. Durch die verwendung eines Revolverbestückkopfes 2 ist es möglich, eine Vielzahl von Flip-Chips in schneller Folge vom Wafer aufzunehmen und zwischen zwei Haltestationen zu wenden. Anschließend wird die Vielzahl der an den Greifern gehaltenen Flip-Chips in ebenso schneller Folge auf das Substrat aufgesetzt. Dadurch verringert sich die Anzahl der Verfahrvorgänge erheblich, was mit einer entsprechenden Zeitersparnis verbunden ist. Der Bestückkopf hat außerdem den Vorteil, daß für sämtliche an den Greifern gehaltenen Bauteile eine einzige Wendestation benötigt wird und daß der jeweilige Greifer nicht den vollständigen Wendevorgang abwarten muß, sondern daß das Bauteil beim Wenden zur nächsten Station gelangt und dort ohne Verlust an Taktzeit wieder aufgenommen werden kann.

Vorteilhafte Weiterbildungen der Erfindung sind in den Ansprüchen 2 bis 5 gekennzeichnet:

Durch die Weiterbildung nach Anspruch 2 wird die Wendeeinrichtung in einfacher Weise mit wenigen zusätzlichen Elementen realisiert.

Durch die Weiterbildung nach Anspruch 3 können Flip-Chips sicher zwischen den verschiedenen Saugflächen übergeben werden.

Durch die Weiterbildung nach Anspruch 4 können ohne Nachstellvorgänge unterschiedlich dicke Flip-Chips gehandhabt werden.

Durch die Weiterbildung nach Anspruch 5 kann die Wendeeinrichtung kompakt und mit geringem Gewicht ausgebildet werden.

Im folgenden wird die Erfindung anhand eines in der Zeichnung dargestellten Ausführungsbeispieles näher erläutert.
- Figur 1: zeigt schematisiert eine Seitenansicht eines Bestuckkopfes für Flip-Chips,
- Figur 2: eine andere Seitenansicht des Bestückkopfes nach Figur 1,
- Figur 3: einen Ausschnitt aus dem Bestückkopf nach Figur 1 in einer anderen Arbeitsphase.

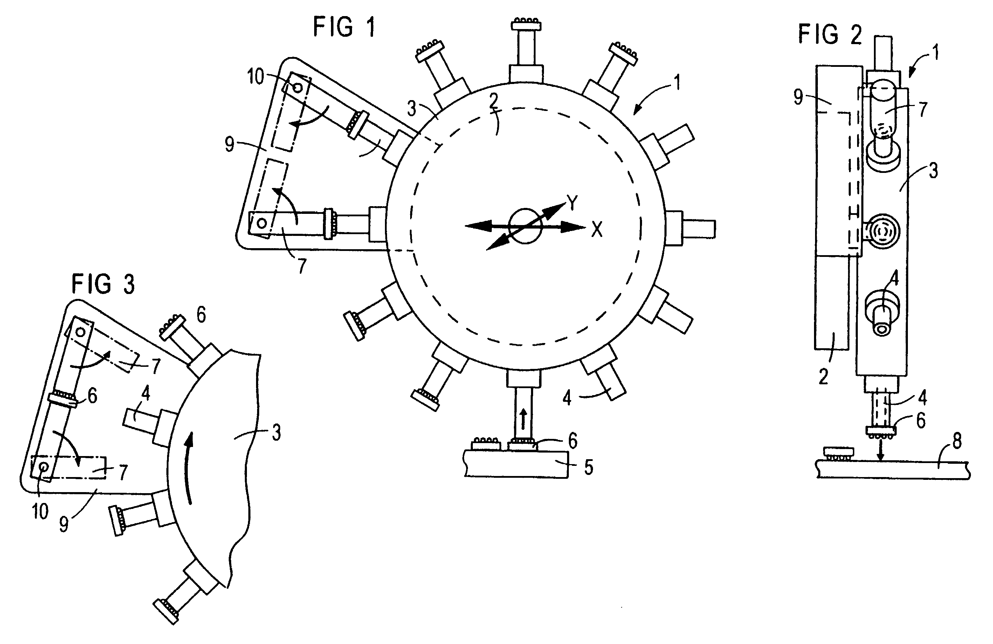

Nach den Figuren 1 und 2 weist ein revolverartiger Bestückkopf 1 einen Stator 2 und einen Rotor 3 auf, an dem eine Vielzahl von sternförmig abstehenden Greifern 4 umlaufend angeordnet ist. Der Bestückkopf 1 ist in der Richtung der perspektivisch dargestellten Pfeile X und Y in einer zum Wafer und dem Substrat parallelen Ebene frei positionierbar. In der in Figur 1 dargestellten Stellung befindet er sich über einem Wafer 5 an dessen Oberseite Flip-Chips 6 eng aneinandergereiht mit ihrer Anschlußseite nach oben liegend bereitgehalten sind.

Der in der unteren Drehstellung befindliche Greifer 4 ist auf einen der Flip-Chips 6 ausgerichtet und kann teleskopartig auf diesen abgesenkt werden. Dieser wird an das Greiferende angesaugt und zusammen mit diesem vom Wafer 5 abgehoben. Durch Verfahren des Bestückkopfes 1 und Verdrehen des Rotors 3 können·sukzessive sämtliche Greifer 4 mit den Flip-Chips 6 belegt werden. Einer der Haltestationen der Greifer 4 ist ein erster Halter 7 zugeordnet, der mit seinem Ende auf das Ende des Greifers 4 ausgerichtet ist.

Der am Greifer angesaugte Flip-Chip 6 kann nun an den Halter 7 übergeben werden und an dessen Ende angesaugt werden. Durch Verschwenken in eine strichpunktiert dargestellte Übergabe-Stellung kann der Flip-Chip 6 an einen weiteren Halter 7 übergeben werden, der dem ersten Halter entgegengesetzt gerichtet ist und der nun den Flip-Chip 6 an seiner Anschlußseite erfaßt. Der zweite Halter 7 ist einer nachfolgenden Haltestation des Bestückkopfes 1 zugeordnet. Er kann aus der Übergabestellung in eine zum Greifer 4 der zweiten Haltestation fluchtende Abgabestellung geschwenkt werden, in der der Greifer 4 das Bauelement an seiner der Anschlußseite abgewandten Oberseite erfaßt.

In Figur 3 ist dargestellt, wie der Flip-Chip 6 während des Verdrehens des Rotors 3 zwischen den Haltern 7 übergeben und zeitsparend gewendet werden kann.

Nach dem Wenden der Flip-Chips 6 werden diese sukzessive in eine in der Figur 2 dargestellte Aufsetzstellung transportiert, in der sie auf ein zu bestückendes Substrat 8 lagerichtig aufgesetzt werden können.

## Patentansprüche

1. Vorrichtung zum Bestücken eines als Schaltungsträger ausgebildeten Substrates (8) mit Flip-Chips (6),
wobei die Vorrichtung einen verfahrbaren Bestückkopf (1) aufweist, der die Flip-Chips (6) aus einem Bauelementevorrat (z.B. 5) entnimmt und auf das Substrat (8) aufsetzt,
**dadurch gekennzeichnet,**
**daß** der Bestückkopf (1) mit einer Wendeeinrichtung (9) für die Flip-Chips (6) versehen ist,
**daß** der Bestückkopf (1) mit einer Vielzahl von revolverartig indexiert umlaufenden Greifern (4) versehen ist,
**daß** die Wendeeinrichtung (9) einem stationären Teil (z.B. 2) des Bestückkopfes (1) zugeordnet ist,
**daß** die wendeeinrichtung (9) jeweils einen der Flip-Chips (6) in einer ersten Haltestation der Greifer (4) Übernimmt und in einer der nachfolgenden Haltestationen an einen der Greifer (4) gewendet zurückgibt.

2. Vorrichtung nach Anspruch 1,
**dadurch gekennzeichnet,**
**daß** die Wendeeinrichtung (9) zwei schwenkbare Halter (7) aufweist, von denen ein erster auf die erste der Haltestationen ausrichtbar ist,
**daß** der zweite Halter (7) auf eine nachfolgende der Haltestationen ausrichtbar ist und
**daß** die beiden Halter (7) in eine gemeinsame Ubergabestellung schwenkbar sind, in der ihre dem Flip-Chip (6) tragenden, einander entgegenragenden Enden aufeinander ausgerichtet sind.

3. Vorrichtung nach Anspruch 2,
**dadurch gekennzeichnet ,**
**daß** die Halter (7) als schwenkbar gelagerte Saugpipetten ausgebildet sind,
**daß** die Greifer (4) als am Bestückkopf (1) radial abstehende Sauggreifer ausgebildet sind,
**daß** die zur Drehebene der Greifer (4) senkrechten Schwenkachsen (10) der Halter (7) in der axialen Verlängerung der Greifer (4) angeordnet sind und daß Längsachsen der Halter und der Greifer beim wechselseitigen Übergeben der Flip-Chips miteinander fluchten.

4. Vorrichtung nach einem der vorhergehenden Ansprüche, **dadurch gekennzeichnet,**
**daß** zwischen den in der Übergabestellung fluchtenden gegeneinander gerichteten Haltern (7) ein freier Abstand besteht, der etwas größer ist, als die Dicke der Flip-Chips (6).

5. Vorrichtung nach einem der vorhérgehenden Ansprüche,
**dadurch gekennzeichnet,**
**daß** die erste und zweite Haltestation unmittelbar aufeinanderfolgend angeordnet sind.

## Claims

1. Device for placing flip chips (6) on a substrate (8) in the form of a leadframe, the device having a movable placement head (1), which picks up the flip chips (6) from a stock of components (for example 5) and places them on the substrate (8), **characterized in that** the placement head (1) is provided with a turning device (9) for the flip chips (6), **in that** the placement head (1) is provided with a multiplicity of grippers (4) circulating in a turret-like indexed manner, **in that** the turning device (9) is assigned to a stationary part (for example 2) of the placement head (1), **in that** the turning device (9) respectively takes over one of the flip chips (6) in a first holding station of the grippers (4) and returns it, after turning, to one of the grippers (4) in one of the downstream holding stations.

2. Device according to Claim 1, **characterized in that** the turning device (9) has two pivotable holders (7), one of which can be aligned with the first of the holding stations, **in that** the second holder (7) can be aligned with one of the downstream holding stations and **in that** the two holders (7) can be pivoted into a mutual transfer position, in which their ends, carrying the flip chip (6) and projecting towards each other, are aligned with each other.

3. Device according to Claim 2, **characterized in that** the holders (7) are designed as pivotably mounted suction pipettes, **in that** the grippers (4) are designed as suction grippers protruding radially from the placement head (1),
**in that** the pivoting axes (10), perpendicular to the turning plane of the grippers (4), of the holders (7) are arranged in axial extension of the grippers (4) and **in that** longitudinal axes of the holders and of the grippers are in line with one another during the transfer between them of the flip chips.

4. Device according to one of the preceding claims, **characterized in that** between the holders (7) directed oppositely facing other and in line with each other in the transfer position there is a clearance, which is somewhat larger than the thickness of the flip chips (6).

5. Device according to one of the preceding claims, **characterized in that** the first and second holding stations are arranged immediately following each other.

## Revendications

1. Dispositif de pose de puces de type flip-chip (6) sur un substrat (8) réalisé en tant que support de circuits, le dispositif comportant une tête de pose (1) déplaçable qui prend les puces de type flip-chip (6) d'un stock de composants (5, par exemple) et les pose sur le substrat (8),
**caractérisé en ce que**
la tête de pose (1) est équipée d'un dispositif de retournement (9) pour les puces de type flip-chip (6);
la tête de pose (1) est équipée d'une pluralité de préhenseurs (4) périphériques indexés à la manière d'un revolver;
le dispositif de retournement (9) est affecté à une partie stationnaire (2, par exemple) de la tête de pose (1) et
le dispositif de retournement (9) prend en charge respectivement l'une des puces de type flip-chip (6) à une première station d'arrêt des préhenseurs (4) et la remet retournée à l'un des préhenseurs (4) à l'une des stations d'arrêt suivantes.

2. Dispositif selon la revendication 1,
**caractérisé en ce que**
le dispositif de retournement (9) comporte deux supports (7) pivotants dont un premier peut être dirigé vers la première des stations d'arrêt,
le deuxième support (7) peut être dirigé vers l'une suivante des stations d'arrêt et
les deux supports (7) peuvent subir un pivotement pour passer dans une position de transfert commune dans laquelle leurs extrémités portant la puce de type flip-chip (6), tournées l'une dans le sens opposé de l'autre, sont dirigées l'une vers l'autre.

3. Dispositif selon la revendication 2,
**caractérisé en ce que**
les supports (7) sont réalisés en tant que pipettes aspirantes montées de manière à pouvoir pivoter;
les préhenseurs (4) sont réalisés en tant que préhenseurs par succion partant radialement de la tête de pose (1);
les axes de pivotement (10) des supports (7) perpendiculaires par rapport au plan de rotation des préhenseurs (4) sont situés dans le prolongement axial des préhenseurs (4) et
des axes longitudinaux des supports et des préhenseurs sont alignés l'un avec l'autre lors du transfert réciproque des puces de type flip-chip.

4. Dispositif selon l'une des revendications précédentes,
**caractérisé par**
la présence, entre les supports (7) alignés en position de transfert et orientés de manière opposée l'un à l'autre, d'un espace libre un peu supérieur à l'épaisseur des puces de type flip-chip (6).

5. Dispositif selon l'une des revendications précédentes,
**caractérisé en ce que**
les première et deuxième stations d'arrêt sont disposées de manière à se succéder directement.
